Europäisches Patentamt

European Patent Office

Office européen des brevets

(19)

(11) Numéro de publication: **0 034 963**

**A1**

(12)

# DEMANDE DE BREVET EUROPEEN

(21) Numéro de dépôt: **81400183.0**

(22) Date de dépôt: **06.02.81**

(51) Int. Cl.³: **G 01 R 21/00**

(30) Priorité: **19.02.80 FR 8003565**

(43) Date de publication de la demande:
**02.09.81 Bulletin 81/35**

(84) Etats contractants désignés:
**AT BE CH DE FR GB IT LI NL SE**

(71) Demandeur: **ENERTEC SOCIETE ANONYME**
**12, Place des Etats Unis**
**F-92120 Montrouge(FR)**

(72) Inventeur: **Bazin, Alain**
**8 allée Berlioz**
**F-94800 Villejuif(FR)**

(74) Mandataire: **Bentz, Jean-Paul**
**GIERS SCHLUMBERGER 12, Place Des Etats Unis**
**F-92124 Montrouge Cedex(FR)**

(54) **Dispositif électronique de mesure pour réseau polyphasé, en particulier pour la mesure de l'énergie.**

(57) Dispositif pour mesurer une grandeur telle que l'énergie électrique sur un réseau alternatif polyphasé comportant au moins deux conducteurs de phase ($P'_1$, $P'_2$) et un conducteur de référence ($N'$), du type comprenant deux dispositifs de mesure ($10_1$, $10_2$) associés respectivement aux deux phases et dont les sorties sont reliées à un totalisateur (358).

Un circuit d'alimentation ($332_2$) relié à l'une des phases est associé au dispositif de mesure ($10_2$) correspondant, et un dispositif ($332_1$) relié à l'autre phase assure l'alimentation de l'autre dispositif de mesure ($10_1$) et du totalisateur (358), le circuit d'alimentation ($332_2$) et le dispositif ($332_1$) d'alimentation étant reliés par un circuit de liaison à forte impédance (C 340, R 341), le totalisateur (358) étant alimenté si l'une au moins des phases ($P'_1$, $P'_2$) est sous tension par rapport au conducteur de référence ($N'$).

Fig. 7

## DISPOSITIF ELECTRONIQUE DE MESURE POUR RESEAU POLYPHASE EN PARTICULIER POUR LA MESURE DE L'ENERGIE

La présente invention concerne des dispositifs pour produire un signal fonction de plusieurs grandeurs mesurées sur plusieurs phases d'un circuit de distribution d'énergie électrique polyphasé, notamment des dispositifs dont le signal de sortie est fonction de la puissance transitant à travers une ou plusieurs desdites phases.

On sait que l'énergie consommée dans un réseau électrique polyphasé est la somme des énergies effectivement consommées sur chacune des phases et les compteurs d'énergie polyphasés comportent à cet effet des dispositifs permettant de mesurer des paramètres électriques concernant plusieurs phases pour déterminer l'énergie correspondante.

On a proposé récemment, par exemple dans la demande de brevet français 78 13998 déposée le 11 mai 1978 et publiée sous le numéro 23 91 474, un compteur d'énergie comportant un dispositif électronique de mesure qui reçoit sur ses entrées un signal représentatif du courant sur une phase à laquelle il est associé et un signal représentatif de la tension d'alimentation de cette phase et émet à sa sortie un train d'impulsions dont la fréquence est proportionnelle à l'énergie transitant par cette phase.

Dans un compteur polyphasé fonctionnant sur ce principe on utilise plusieurs dispositifs de mesure électronique, chacun associé à une phase respective, dont on totalise alors les impulsions de sortie pour obtenir le compte de l'énergie totale à l'aide d'un circuit de totalisation approprié.

Certains de ces dispositifs de mesure électroniques sont conçus pour dériver leurs signaux d'entrée de la phase associée sans l'intermédiaire de transformateurs de tension ou de courant. Un signal représentatif du courant est notamment dérivé à partir de la chute de tension aux bornes d'un shunt branché sur cette phase. Un signal représentatif de la tension est obtenu à l'aide d'un diviseur de tension et un circuit d'alimentation produit à l'entrée du dispositif de mesure une tension continue sensiblement stable par rapport au potentiel de la phase, sans employer de transformateur.

Ainsi, le dispositif électronique de mesure et son circuit d'alimentation associé "flottent" avec le potentiel de la phase, un circuit à forte impédance fournissant la continuité électrique entre ce circuit d'alimentation et un potentiel distinct de celui de la phase considérée tel que celui d'un conducteur de neutre.

Dans un compteur branché sur un réseau polyphasé, les dispositifs de mesure et leur alimentation sont donc portés à des tensions qui peuvent être très différentes les unes des autres et fluctuent dans des limites assez larges les unes par rapport aux autres. Il en résulte que le totalisateur d'impulsions à la sortie de ces circuits doit normalement être isolé galvaniquement par rapport à certains au moins de ceux-ci. Par ailleurs, il est souhaitable que son alimentation puisse être directement dérivée du réseau sans faire intervenir de transformateur de tension coûteux. Cette alimentation doit fonctionner quel que soit le nombre de phases du réseau polyphasé qui sont effectivement sous tension, afin de comptabiliser l'énergie qui transite même par une seule phase si les autres phases du réseau sont coupées.

Il est en outre souhaitable de résliser cette alimentation avec un minimum de composants.

L'invention a pour objet un dispositif de mesure d'une grandeur sur un réseau de distribution électrique alternatif polyphasé comportant au moins un premier et un second conducteur de phase et un conducteur de référence, du type comprenant un premier et un second dispositifs électroniques de mesure pour produire un signal représentatif de ladite grandeur, mesurée respectivement sur le premier et le second conducteurs de phase, et un dispositif sommateur fournissant la somme des signaux ainsi produits, caractérisé par le fait qu'il comprend un premier circuit d'alimentation relié au premier conducteur de phase pour appliquer une tension d'alimentation continue au premier dispositif de mesure, un dispositif d'alimentation, relié au second conducteur de phase, pour appliquer une tension d'alimentation continue au second dispositif de mesure et une tension d'alimentation continue au dispositif sommateur, et un circuit de liaison à forte impédance monté entre le premier circuit d'alimentation et le dispositif d'alimentation, l'agencement étant tel que le dispositif sommateur est alimenté dès que l'un des conducteurs de phase est sous tension par rapport au conducteur de référence.

Le circuit de liaison à forte impédance est ainsi utilisé non seulement pour l'alimentation du premier dispositif de mesure, mais aussi pour l'alimentation du
dispositif sommateur. Il en résulte une économie appréciable de composants.

Dans une première forme de réalisation, le dispositif
d'alimentation comprend un second circuit d'alimentation relié au second conducteur de phase pour appliquer
une tension d'alimentation continue au second dispositif de mesure , un second circuit de liaison à forte
impédance relié au second circuit d'alimentation et un
circuit d'alimentation supplémentaire monté entre les
deux circuits de liaison et le conducteur de référence
pour appliquer au dispositif sommateur une tension
d'alimentation sensiblement stable par rapport au potentiel du conducteur de référence.

Les circuits de liaison à forte impédance étant montés
entre les circuits d'alimentation respectifs des dispositifs de mesure et le circuit supplémentaire , celui-
ci peut "flotter" avec le potentiel du conducteur de
référence, à l'abri des surtensions.

Dans une autre forme de réalisation, le dispositif
d'alimentation est constitué d'un second circuit d'alimentation identique au premier, le dispositif sommateur
étant relié pour son alimentation à ce second circuit
d'alimentation et au second conducteur de phase.

Dans ce cas, comme le second dispositif de mesure et le dispositif sommateur sont alimentés par le même circuit, on économise un circuit d'alimentation. De plus, on peut se dispenser d'une liaison à isolement galvanique entre le second dispositif de mesure et le dispositif sommateur.

D'autres aspects et avantages de l'invention apparaîtront à la lecture de la description suivante de divers modes de réalisation, faite en référence aux dessins annexés sur lesquels :

- la figure 1 est un schéma de branchement d'un dispositif électronique de comptage d'énergie dont le principe est utilisé dans le dispositif de la figure 2 ;

- la figure 2 représente un dispositif selon l'invention, dans le cas de la mesure de l'énergie dans un réseau triphasé quatre fils ;

- la figure 3 représente une variante de réalisation par rapport au dispositif de la figure 2 ;

- la figure 4 représente une autre variante de réalisation ;

- la figure 5 montre un dispositif destiné à la mesure de l'énergie dans le cas d'un réseau triphasé trois fils ;

- la figure 6 représente un dispositif destiné à la mesure de l'énergie dans le cas d'un réseau à deux phases en opposition et un conducteur de neutre ;

- la figure 7 représente une autre forme de réalisation de l'invention, dans le cas d'un réseau à deux phases en opposition et un conducteur de neutre ;

- la figure 8 représente un dispositif du même type que celui de la figure 7, destiné à la mesure de l'énergie dans le cas d'un réseau triphasé trois fils.

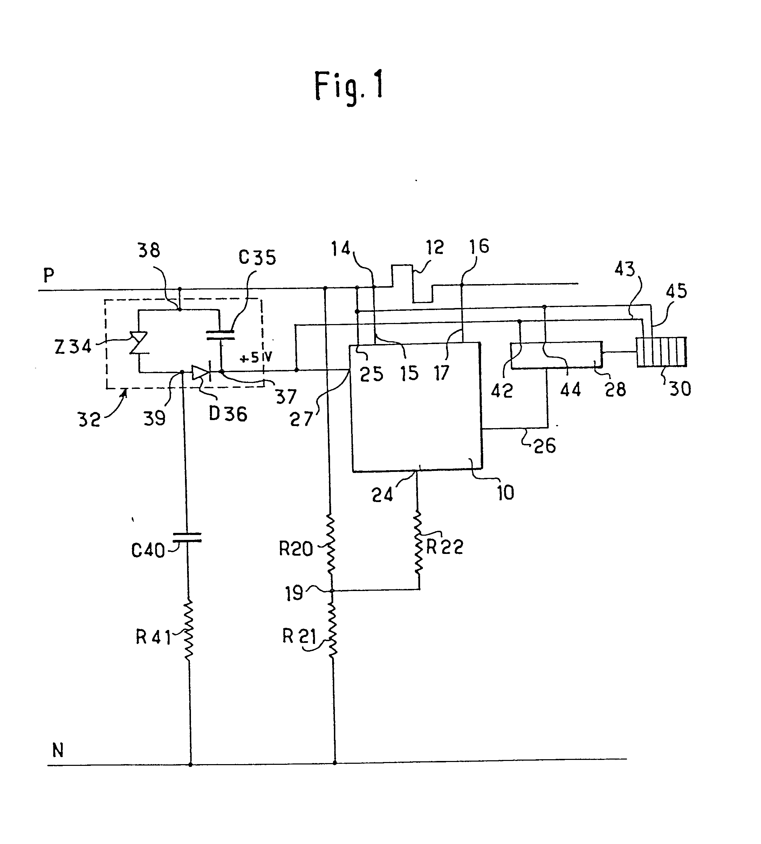

On a représenté sur la figure 1 un dispositif de comptage d'énergie électronique branché entre un conducteur de neutre N et un conducteur de phase P d'un réseau de distribution d'énergie électrique monophasé pour une installation domestique sous une tension de 110 ou 220 volts par exemple.

Ce dispositif correspond à un objet de la demande de brevet français susmentionnée publiée sous le numéro 23 9I 474. Il comporte essentiellement un circuit de comptage électronique 10 réalisé sous forme d'un circuit intégré à large échelle (LSI), raccordé sans transformateur au réseau alternatif monophasé P, N. Un shunt 12 est interposé sur la phase P, aux bornes I4 et I6 duquel est branché le circuit de comptage I0, pour fournir entre ses entrées I5 et I7 une tension proportionnelle au courant traversant le fil actif ou conducteur de phase P. Le circuit de comptage I0 est par ailleurs connecté par une résistance R 22 à la jonction I9 d'un diviseur de tension R20, R2I qui se trouve branché entre le conducteur de phase P et le neutre N. La résistance R2I a une valeur très supérieure à la résistance R 20 de telle sorte que la tension entre la jonction I9 des deux résistances et le conducteur de phase P soit relativement faible, et fournisse aux entrées 24 et 25 du circuit de comptage un signal représentatif de la tension de phase de l'ordre de 0,5 volts.

Le circuit de comptage effectue le produit du signal de tension instantanée présent entre ses entrées 24,25 et du signal représentatif du courant instantané présent

entre les entrées I5, I7, et la conversion de ce produit en impulsions dont la fréquence est proportionnelle à la puissance transitant par la phase P. Ces impulsions sont transmises à la sortie 26 du circuit de comptage pour être totalisées dans un compteur totalisateur électronique 28 dont la sortie est reliée à un afficheur 30, par exemple du type à cristaux liquides.

Afin d'alimenter le circuit de comptage IO, le totalisateur 28 et son affichage 30, une alimentation 32 est branchée sans transformateur entre le conducteur de phase P et le conducteur de neutre N. Elle comporte un montage parallèle d'une diode Zener Z 34 et d'un circuit série formé d'un condensateur C 35 et d'une diode D 36. Une extrémité 38 de ce montage parallèle est reliée au conducteur de phase P et l'autre extrémité 39 de ce montage est raccordée au conducteur de neutre N par l'intermédiaire d'un condensateur C 40 et d'une résistance R 4I en série. La jonction 37 du condensateur et de la diode est reliée à une entrée 27 d'alimentation du circuit LSI IO.

Le circuit de liaison formé par le condensateur C 40 et la résistance R 4I présente une impédance relativement forte pour faire chuter la tension entre la jonction 39 et le neutre N tout en minimisant les pertes de puissance, en particulier de puissance active conformément aux normes imposées dans le domaine du comptage d'énergie électrique.

Le condensateur C 40 est dimensionné de façon à être à l'origine de la plus grande partie de cette chute de tension, sans consommation de puissance active. Une partie relativement faible de cette chute de tension est due à la résistance R 4I, destinée à atténuer les ondes de choc sur le réseau de façon à protéger le circuit d'alimentation 32 auquel elle est connectée.

Lorsque les conducteurs de phase et neutre sont alimentés par une tension alternative à la fréquence nominale du réseau, la diode Zener Z 34 délivre à ses bornes une tension en créneaux rectangulaires dont l'amplitude peut être par exemple égale à 5 volts, valeur à laquelle elle charge le condensateur C 35 par l'intermédiaire de la diode D 36, de sorte que la tension de la jonction 37 par rapport au conducteur de phase P s'établit à une valeur pratiquement continue de + 5 volts. Cette tension est utilisée pour alimenter le circuit de comptage IO par ses entrées 25 , reliée à la phase P, et 27, reliée à la jonction 37.

Le totalisateur 28 et l'afficheur 30 sont également raccordés à l'alimentation 32 par l'intermédiaire de conducteurs respectifs 42 et 43, reliés à la jonction 39, et 44, 45, reliés à la phase P.

Lorsque le réseau est alimenté, le circuit 32, le circuit de comptage IO, le totalisateur 28 et son afficheur 30 "flottent" électriquement avec le potentiel de phase, toutes les tensions appliquées étant rapportées au potentiel de la phase P.

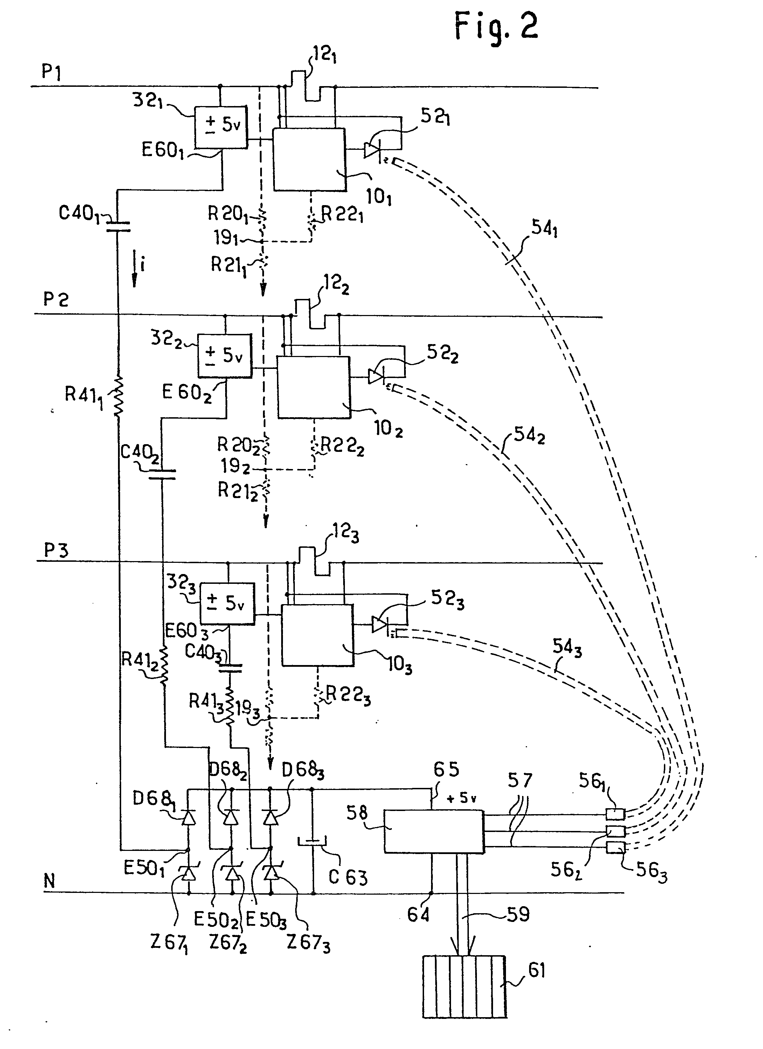

La figure 2 représente un dispositif utilisant des montages tels que celui de la figure I pour le comptage de l'énergie transmise à un circuit triphasé quatre fils, c'est-à-dire comportant trois conducteurs de phase Pl, P2, P3 et un conducteur de neutre N qui peut être ou non raccordé à la terre.

A chacune des phases Pl, P2, P3 est associé un circuit de comptage $IO_1$, $IO_2$, $IO_3$ respectivement. Ces circuits de comptage reçoivent un signal représentatif du courant dans la phase respective à partir de shunts $I2_1$, $I2_2$, $I2_3$, et un signal de tension à l'aide de résistances et diviseur de tension respectifs, représentés en tirets sur la figure 2 et branchés entre la phase respective et le conducteur de neutre, ces diviseurs étant repérés par les références $R20_1$ - $R2I_1$, $R20_2$ - $R2l_2$ et $R20_3$ - $R2I_3$. D'une façon générale, les éléments identiques à ceux de la figure 1 sont repérés par des numéros de référence identiques munis de l'indice de la phase à laquelle ils sont associés.

Afin d'assurer l'alimentation de chacun des circuits de comptage $IO_1$ à $IO_3$, il est prévu des circuits d'alimentation respectifs $32_1$, $32_2$ et $32_3$ connectés de façon similaire à l'alimentation 32 de la figure 1.

En particulier, chacun de ces circuits d'alimentation est relié au neutre par l'intermédiaire d'un circuit de liaison à forte impédance comportant un condensateur tel que C $40_1$ en série avec une résistance telle que R $41_1$ pour le circuit d'alimentation $32_1$, chacun de ces circuits jouant le rôle indiqué précédemment à propos du circuit C 40, R 4I.

Chaque circuit de comptage $IO_1$ à $IO_3$ possède une sortie débitant sur une diode électro-luminescente, respectivement $52_1$ à $52_2$, associée à une extrémité d'une liaison à fibres optiques respective $54_1$ à $54_3$, dont l'extrémité opposée transmet aux entrées respectives d'un phototransistor $56_1$ à $56_3$ des impulsions lumineuses correspondant aux impulsions de sortie du circuit $IO_1$ à $IO_3$. Les phototransistors $56_1$ à $56_3$ sont connectées par des conducteurs 57 aux entrées d'un circuit de sommation 58 de conception connue qui effectue la totalisation des impulsions reçues sur ses trois entrées en provenance des phototransistors $56_1$ à $56_3$.

Ce totalisateur est raccordé par une liaison multifils 59 à un afficheur à cristaux liquides 6I qui indique l'énergie mesurée par le compteur triphasé. Le totalisateur et son système d'affichage peuvent être également réalisés par tout autre système équivalent, par exemple un solénoïde dont l'excitation par impulsion peut provoquer la rotation, par l'intermédiaire d'une roue à rochet, d'un totalisateur à rouleaux selon un principe utilisé dans les compteurs téléphoniques, ou à l'aide d'un moteur pas à pas entraînant un totalisateur à rouleaux en réponse à chaque impulsion.

Les liaisons optiques $54_1$ à $54_3$ sont destinées à réaliser une isolation convenable entre le totalisateur 58 d'une part et chacune des phases P1 à P3 ainsi qu'entre ces phases, leurs niveaux de tension respectifs étant très différents.

0034963

- 11 -

Il est nécessaire en outre que le système de totalisation et d'affichage utilisé pour le compteur triphasé puisse fonctionner même si l'une des phases seulement est alimentée, les deux autres se trouvant hors tension, et il est tout à fait souhaitable d'utiliser le courant fourni par le réseau sur lequel est branché le compteur pour le faire fonctionner. A cet effet, le totalisateur 58 est alimenté sous une tension continue de + 5 volts par rapport au conducteur de neutre de la façon suivante.

Un condensateur chimique C 63 est branché entre deux bornes 64 et 65 d'alimentation du totalisateur 58, la borne 64 étant reliée au conducteur de neutre N. En parallèle avec le condensateur C 63 sont également montées trois branches de redresseur comportant chacune une diode Zener $Z\ 67_1$ à $Z\ 67_3$ et une diode redresseuse, $D\ 68_1$ à $D\ 68_3$, connectées dans le sens allant de la borne 64 vers la borne 65. Chacune de ces branches de redressseur est reliée à un des circuits de liaison à forte impédance déjà mentionnés qui possèdent chacun une extrémité $E\ 60_1$ à $60_3$, connectée à l'entrée du circuit d'alimentation $32_1$ à $32_3$ correspondant, leur autre extrémité $E\ 50_1$ à $E\ 50_3$ étant connectée dans la branche de redresseur correspondante, à la jonction de la diode Zener et de la diode redresseuse respectives.

Ainsi, en fonctionnement, chacune des diodes Zener $Z\ 67_1$ à $Z\ 67_3$ délivre à ses bornes une tension en créneaux rectangulaires d'amplitude légèrement supérieure à 5 volts qui tend à maintenir le condensateur C 63 chargé à travers les diodes $D\ 68_1$ à $D\ 68_3$ à une tension d'environ 5 volts, compte tenu de la chute de tension propre des diodes. Le condensateur C 63 alimente donc les entrées 64 et 65 du totalisateur 58 sous une tension continue stable. On remarquera que chaque branche de redresseur en parallèle connectée aux jonctions E $50_1$ à E $50_3$ réalise en liaison avec le condensateur C 63 une alimentation stabilisée indépendante, ce qui permet d'obtenir une tension d'alimentation du totalisateur dès que l'une des phases P1, P2 ou P3 est mise sous tension par rapport au conducteur de neutre N ou, inversement, aussi longtemps que l'une au moins de ces phases reste en service. On remarque également que le branchement qui vient d'être décrit empêche toute interaction entre les circuits à forte impédance associés aux alimentations $32_1$ à $32_3$ grâce au blocage réalisé par les diodes D $68_1$ à D $68_3$ qui jouent le rôle d'une fonction logique OU à l'égard des signaux d'entrée de l'alimentation du totalisateur 58.

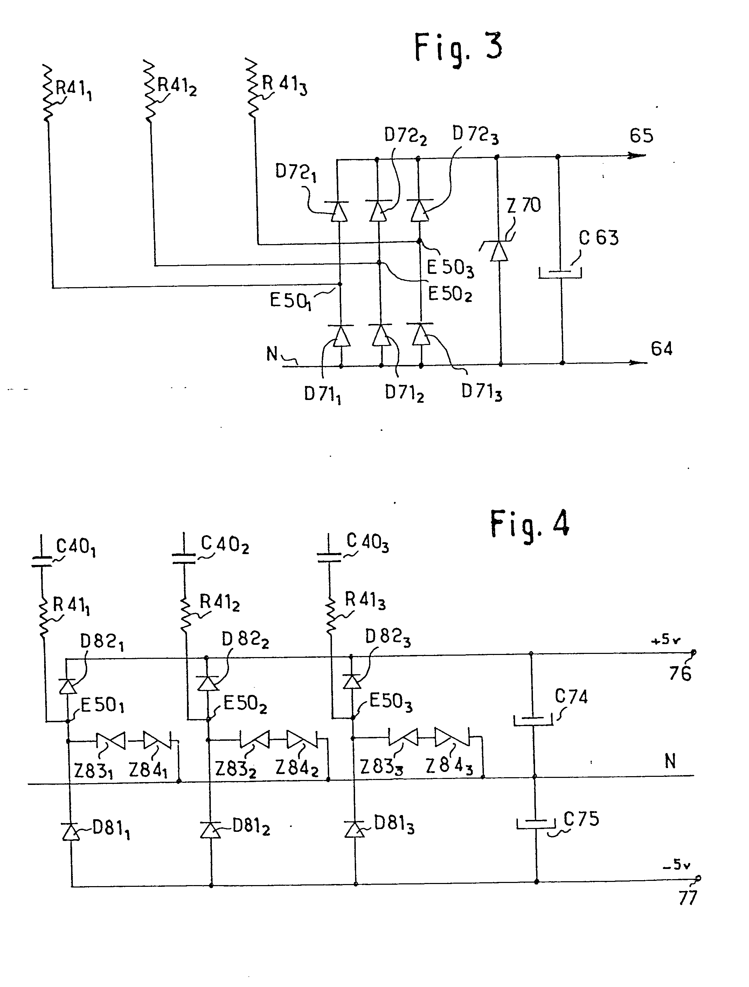

La réalisation de ce circuit d'alimentation peut subir des modifications diverses. Par exemple, si on se réfère à la figure 3 on peut faire l'économie de plusieurs diodes Zener en utilisant une diode Zener stabilisatrice unique Z 70 branchée en parallèle au condensateur C 63 et raccordée directement aux bornes 64 et 65 d'alimentation du totalisateur 58. Outre la diode Zener Z 70, trois branches de redresseur série sont montées en parallèle aux bornes 64 et 65 et sont chacune connectées à une extrémité E $50_1$ , E $50_2$ ou E $50_3$ d'un circuit de liaison à forte impédance respectif.

Chacune de ces branches de redresseur comporte deux diodes en série orientées dans le sens de la borne 64 vers la borne 65 et repérées par les références $D\ 7I_1$ et $D\ 72_1$ pour la branche reliée à la deuxième extrémité $E\ 50_1$ au point de jonction de ces diodes, les autres branches étant constituées par des branchements série de diodes de numérotation identique affectées d'indices correspondant à la phase à laquelle elles sont associées.

Chacune des branches $D\ 7I$ - $D\ 72$ fournit une tension redressée et stabilisée au niveau fixé par la diode Zener $Z\ 70$ au condensateur $C\ 63$ afin d'alimenter le circuit de totalisation 58. Les branches de redresseur agissent indépendamment les unes des autres et il suffit qu'une d'entre elles soit excitée pour que le totalisateur soit alimenté.

Il est possible de réaliser à l'aide des principes décrits une alimentation bi-polaire pour les circuits de totalisation et d'affichage 58 et 6I, ou d'ailleurs tout autre circuit d'exploitation des données en provenance des circuits de comptage $IO_1$ à $IO_3$, une telle alimentation fournissant deux tensions d'alimentation continues de polarités opposées.

La figure 4 représente une telle réalisation dans laquelle deux condensateurs $C\ 74$ et $C\ 75$ sont raccordés au neutre N par une de leurs armatures, l'autre armature de $C\ 74$ étant reliée à une borne 76 d'alimentation sous tension continue de + 5 volts tandis que l'autre armature de condensateur $C\ 75$ est reliée à une borne 77 d'alimentation sous tension continue de - 5 volts.

Trois branches de redresseur sont prévues, chacune associée à une des phases P1 à P3 par l'intermédiaire de la deuxième extrémité, E $50_1$ à E $50_3$ du circuit de liaison à forte impédance correspondant. Cette extrémité est raccordée à la jonction de deux diodes, orientées de la borne 77 vers la borne 76 et respectivement repérées par les numéros de référence D 8I et D 82 des indices correspondant à la phase à laquelle ils sont associés.

Entre chacune des extrémités E $50_1$ à E $50_3$ et le neutre N sont également connectées deux diodes Zener en opposition Z 83 et Z 84, affectés des indices correspondant à leur phase associée, de façon à maintenir la tension entre les points E $50_1$ à E $50_3$ et le neutre à l'une des deux valeurs égales et opposées de part et d'autre du potentiel du conducteur de neutre N, selon la polarité du courant traversant le circuit à forte impédance respectif. Chacune des diodes Zener Z 83 stabilise la tension aux bornes du condensateur C 74 à une valeur positive tandis que chacune des diodes Zener Z 84 agit de la même façon pour maintenir la tension aux bornes du condensateur C 75 à une valeur égale mais négative. Comme précédemment, l'agencement ou le branchement des diodes D 8I et D 82 réalise une fonction logique OU empêchant toute interaction entre les circuits de liaison à forte impédance.

On constate que l'on a ainsi réalisé avec un minimum de composants une alimentation pour un circuit, tel que le totalisateur 58 et son affichage 6I, exploitant des impulsions en provenance des dispositifs de mesure électroniques associés à chacune des phases d'un réseau polyphasé tel que les circuits de comptage $IO_1$ à $IO_3$. En effet, l'alimentation de ce circuit d'exploitation met en oeuvre le même circuit à forte impédance que chacune des alimentations individuelles des circuits de mesure tels que $32_1$ à $32_3$. Ces circuits qui constituent une source de courant pour les alimentations $32_1$ à $32_3$ jouent chacun le même rôle pour l'alimentation du circuit d'exploitation commun (totalisateur, afficheur) qui vient d'être décrite. On optimise ainsi l'emploi de ces circuits à forte impédance en minimisant le nombre de composants requis, chacun permettant non seulement à l'alimentation du dispositif de mesure associé de flotter avec le potentiel de la phase correspondante, mais également à l'alimentation du circuit d'exploitation commun d'être effectuée en référence au potentiel du neutre, à l'abri des ondes de choc susceptibles d'affecter le réseau, tandis qu'une isolation galvanique est maintenue entre les sorties des dispositifs de mesure associés à chaque phase et les entrées du circuit d'exploitation.

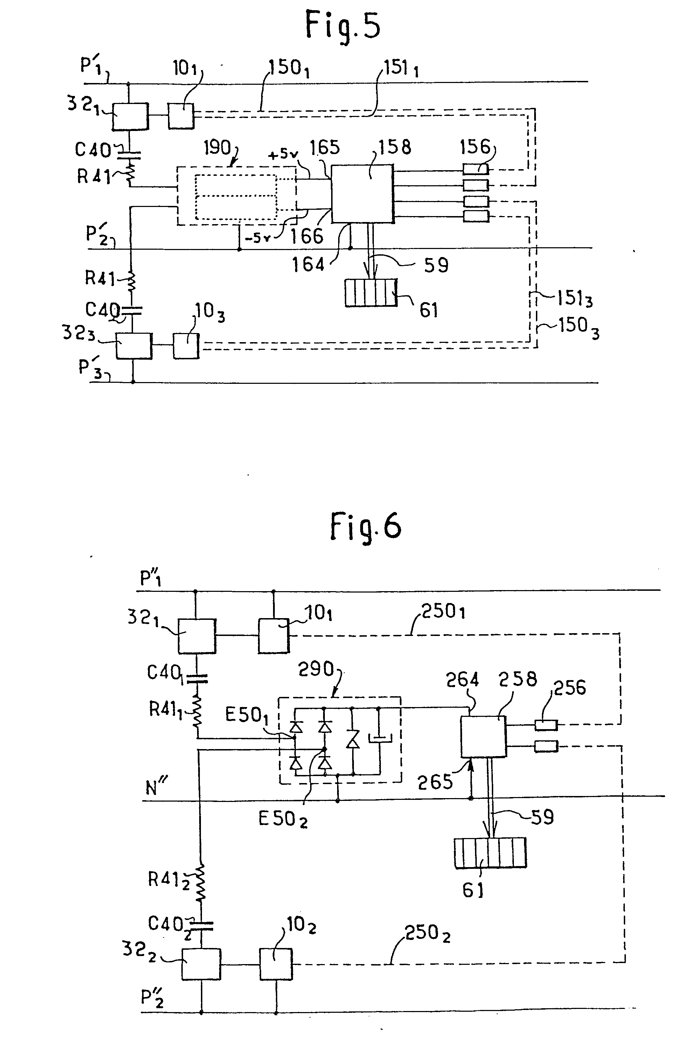

Sur la figure 5, on a représenté un réseau triphasé à trois fils P'1, P'2 et P'3 équipé de deux dispositifs de mesure de la puissance entre phases, l'un d'eux $IO_1$ étant branché entre les phases P'1 et P'2 et l'autre $IO_3$ entre les phases P'3 et P'2. La phase P'2 est ici un conducteur commun dont le potentiel normalement variable est pris comme référence non seulement pour la mesure des tensions d'entrée des circuits de comptage $IO_1$ et $IO_3$ mais également pour la tension d'alimentation des circuits $32_1$ et $32_3$ correspondants.

Les mêmes numéros de référence ont été utilisés pour désigner les mêmes éléments que dans les figures 2 à 4. Seules les quelques différences avec ce qui précède sont abordées plus en détail ci-après.

A chacun des dispositifs de mesure $IO_1$ et $IO_3$ sont associées deux liaisons optiques $I50_1$, $I5I_1$ et $I50_3$, $I5I_3$.

Pour chaque dispositif de mesure, l'une de ces liaisons optiques est destinée à véhiculer des impulsions correspondant à un compte de l'énergie transitant dans un sens par rapport au dispositif, tandis que l'autre liaison est affectée aux impulsions correspondant au comptage de l'énergie dans le sens opposé. Chacune de ces liaisons optiques $I50_1$, $I50_3$, $I5I_1$, $I5I_3$ aboutit à un phototransistor $I56$ relié au circuit de totalisation $I58$ qui effectue l'addition des impulsions correspondant à l'énergie passant dans un sens et la soustraction des impulsions correspondant à l'énergie détectée dans l'autre sens. Ce circuit $I58$ est alimenté à partir d'un circuit d'alimentation $I90$ qui délivre deux tensions continues de $\pm 5$ volts sur les entrées $I65$ et $I66$ du circuit $I58$, prises par rapport à la tension de référence de la phase $P'2$ connectée à son entrée $I64$. Ce circuit $I90$ est alimenté à partir des tensions entre les phases $P'1$ et $P'2$ et entre les phases $P'3$ et $P'2$ ou de l'une de ces deux tensions seulement par l'intermédiaire de circuits à forte impédance $C40$, $R4I$ respectivement associés aux circuits d'alimentation $32_1$ et $32_3$. Il est réalisé par exemple de façon analogue à la représentation de la figure 4, seuls les composants affectés de l'indice 2 étant éliminés. Il "flotte" électriquement ainsi que le circuit $I58$ avec le potentiel de la phase $P'2$.

On peut également, en se référant à la figure 6, considérer un montage pour le comptage de l'énergie délivrée par un circuit diphasé en opposition trois fils, c'est à dire, comportant deux conducteurs de phases $P''1$ et $P''2$ alimentés sous des tensions en opposition (déphasage de $180°$) par rapport à un neutre $N''$.

Dans ce cas chaque dispositif de mesure $IO_1$, $IO_2$ est associé à une seule liaison optique $250_1$, $250_2$ en direction d'un circuit de totalisation 258 qui effectue l'addition des impulsions reçues en provenance des deux circuits $IO_1$ et $IO_2$. Une alimentation 290 qui peut être du type monopolaire représenté à la figure 3 fournit une tension stabilisée par rapport au potentiel de neutre $N''$ à l'entrée 264 du totalisateur 258. Cette alimentation a deux entrées auxquelles sont connectées les extrémités $E\ 50_1$ et $E\ 50_2$ des circuits à forte impédance $C\ 40_1$ et $C\ 40_2$ associés respectivement aux alimentations $32_1$ et $32_2$ des dispositifs $IO_1$ et $IO_2$.

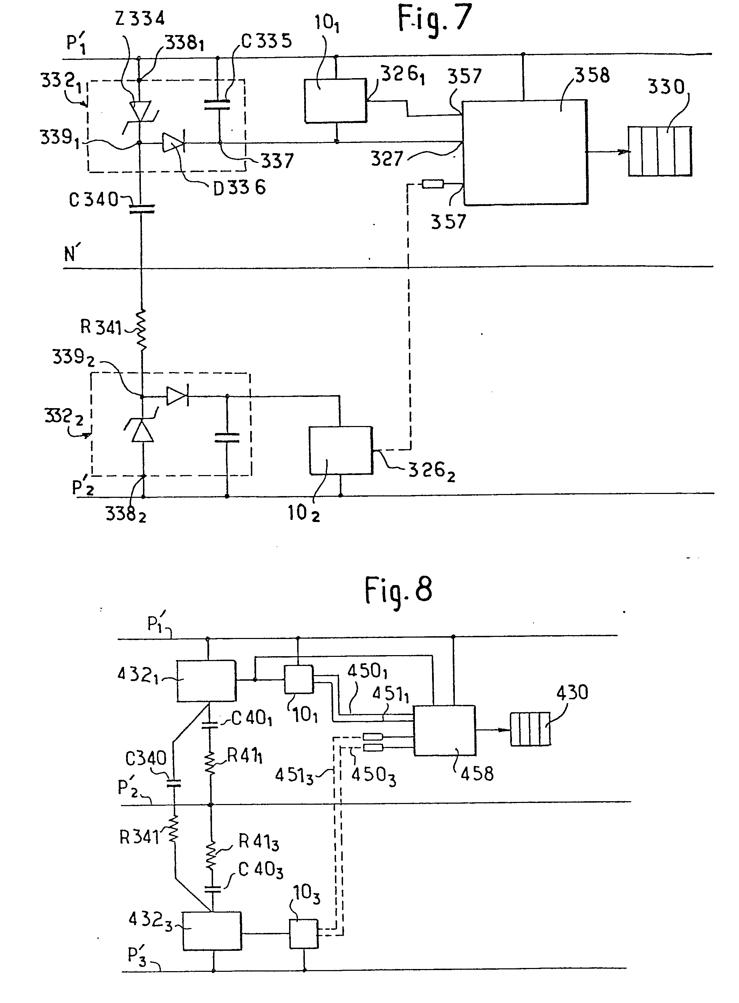

La figure 7 représente une autre forme de réalisation pour le comptage de l'énergie dans un réseau diphasé en opposition à trois fils $P'1$, $P'2$ et $N'$, analogue à celui de la figure 6. Deux dispositifs de mesure électroniques $IO_1$ et $IO_2$ sont associés respectivement aux conducteurs de phase $P'1$ et $P'2$ et leurs sorties $326_1$ et $326_2$ sont reliées aux entrées 357 d'un totalisateur 358.

Chaque dispositif $IO_1$ et $IO_2$ est alimenté par un circuit d'alimentation respectif $332_1$, $332_2$ réalisé, comme l'alimentation 32 de la figure 1, à l'aide d'une diode Zener Z 334, d'une diode D 336 et d'un condensateur C 335. L'alimentation $332_1$ est connectée à la phase P'1 par son entrée $338_1$ et l'alimentation $332_2$ est connectée à la phase P'2 par son entrée $338_2$. Les entrées $339_1$ et $339_2$ (à la jonction de la diode Zener Z 334 et de la diode D 336 de chaque alimentation) sont reliées par un circuit de liaison commun à forte impédance C 340, R 341, de sorte que chacune des alimentations $332_1$ et $332_2$ dérive son énergie d'entrée des deux phases P'1 et P'2, chacune d'elle flottant électriquement, ainsi que son dispositif de mesure associé $IO_1$, $IO_2$, avec le potentiel de la phase respective P1, P2, à l'une des extrémités respective $339_1$, $339_2$ de la liaison à forte impédance C 340, R 341.

Contrairement aux formes de réalisation décrites précédemment, il n'est pas prévu de circuit d'alimentation spécifique pour le totalisateur 358. Celui-ci est alimenté à partir de l'alimentation $332_1$ par une connexion 337, 327 et flotte électriquement avec la phase P'1. Aucune des alimentations $332_1$, $332_2$ n'est reliée au conducteur de neutre et l'on constate que le totalisateur 358 peut continuer à fonctionner en cas de court-circuit entre l'une des phases et le neutre pour compter l'énergie débitée par l'autre phase.

Le totalisateur 358 et le dispositif de mesure $IO_1$ étant alimentés par le même circuit $332_1$, il n'est pas nécessaire de prévoir entre eux une liaison par conducteur optique assurant l'isolation galvanique, ce qui constitue une économie appréciable. En revanche, la liaison entre la sortie $326_2$ du dispositif de mesure $IO_2$ et l'entrée 357 du totalisateur doit être isolée et est réalisée par un conducteur optique représenté en tirets.

La figure 8 montre un dispositif du même type destiné à un réseau triphasé trois fils tel que celui décrit en liaison avec la figure 5.

Comme on l'a dit, le fil P'2 est pris comme conducteur de référence pour la mesure des tensions d'entrée des circuits de comptage $IO_1$ et $IO_3$.

Les circuits de comptage $IO_1$ et $IO_3$ sont alimentés respectivement par des circuits d'alimentation $432_1$, $432_3$ identiques aux circuits $332_1$, $332_2$ de la figure 7.

Les circuits d'alimentation $432_1$, $432_3$ sont reliés directement au conducteur de référence P'2 par des circuits de liaison à forte impédance formés chacun d'un condensateur C $40_1$ (resp. $C40_3$) et d'une résistance $R4I_1$ (resp. $R4I_3$). En outre, comme dans le dispositif de la figure 7, les circuits d'alimentation sont reliés l'un à l'autre par un circuit à forte impédance formé du condensateur C 340 et de la résistance R 34I.

Le totalisateur 458, auquel est associé un afficheur 430, est alimenté par le circuit d'alimentation $432_1$ et relié à la phase P'1, et "flotte" avec le potentiel de la phase P'1 tout comme le dispositif de mesure $IO_1$.

Grâce à la liaison directe C 340, R 34I entre les circuits d'alimentation, le totalisateur 458 est alimenté même en cas de court-circuit entre les phases P'1 et P'2, le circuit $432_3$ assurant alors l'alimentation du totalisateur.

Comme dans le cas de la figure 5, deux liaisons sont nécessaires entre chaque dispositif de mesure et le totalisateur 458, chaque liaison transmettant les impulsions correspondant à un sens de circulation de l'énergie.

Les liaisons entre le dispositif de mesure $IO_3$ et le totalisateur 458 sont réalisées par des conducteurs optiques $450_3$ et $45I_3$ assurant l'isolation galvanique. Au contraire, les liaisons $450_1$ et $45I_1$ entre le dispositif de mesure $IO_1$ et le totalisateur 458 sont des liaisons électriques simples, l'isolation étant alors superflue puisque ces deux éléments sont alimentés par le même circuit.

REVENDICATIONS

1 - Dispositif de mesure d'une grandeur sur un réseau de distribution électrique alternatif polyphasé comportant au moins un premier et un second conducteur de phase et un conducteur de référence, du type comprenant un premier et un second dispositifs électroniques de mesure pour produire un signal représentatif de ladite grandeur, mesurée respectivement sur le premier et le second conducteurs de phase, et un dispositif sommateur fournissant la somme des signaux ainsi produits , caractérisé par le fait qu'il comprend un premier circuit d'alimentation relié au premier conducteur de phase pour appliquer une tension d'alimentation continue au premier dispositif de mesure, un dispositif d'alimentation, relié au second conducteur de phase, pour appliquer une tension d'alimentation continue au second dispositif de mesure et une tension d'alimentation continue au dispositif sommateur, et un circuit de liaison à forte impédance monté entre le premier circuit d'alimentation et le dispositif d'alimentation, l'agencement étant tel que le dispositif sommateur est alimenté dès que l'un des conducteurs de phase est sous tension par rapport au conducteur de référence.

2 - Dispositif selon la revendication 1, caractérisé par le fait que le dispositif d'alimentation comprend un second circuit d'alimentation relié au second conducteur de phase pour appliquer une tension d'alimentation continue au second dispositif de mesure, un second circuit de liaison à forte impédance relié au second circuit d'alimentation et un circuit d'alimentation supplémentaire monté entre les deux circuits de liaison et le conducteur de référence pour appliquer au dispositif sommateur une tension d'alimentation sensiblement stable par rapport au potentiel du conducteur de référence.

3 - Dispositif selon la revendication 2, caractérisé par le fait que le circuit d'alimentation supplémentaire comprend un conducteur commun relié au dispositif sommateur, un condensateur monté entre le conducteur commun et le conducteur de référence, au moins une diode Zener montée en parallèle avec le condensateur, et des circuits redresseurs montés entre le conducteur de référence et le conducteur commun et reliés respectivement auxdits circuits de liaison, l'ensemble des circuits redresseurs constituant une fonction logique OU.

4 - Dispositif selon la revendication 3, caractérisé par le fait que chaque circuit de liaison comprend un condensateur et une résistance en série et chaque circuit redresseur comprend deux diodes montées de part et d'autre de l'extrémité correspondante du circuit de liaison respectif.

5 - Dispositif selon la revendication 2, caractérisé par le fait que le circuit d'alimentation supplémentaire comprend un conducteur commun relié au dispositif sommateur, un condensateur monté entre le conducteur commun et le conducteur de référence, et pour chaque circuit de liaison, un circuit redresseur reliant l'extrémité correspondante du circuit de liaison respectif au conducteur commun par l'intermédiaire d'une diode et au conducteur de référence par l'intermédiaire d'au moins une diode Zener, l'ensemble des circuits redresseurs formant une fonction logique OU.

6 - Dispositif selon la revendication 5, caractérisé par le fait que pour assurer une alimentation bipolaire du dispositif sommateur, le circuit supplémentaire comprend un second conducteur commun relié au dispositif sommateur, un second condensateur monté entre le second conducteur commun et le conducteur de référence, et pour chaque circuit de liaison, une diode reliant ladite extrémité du circuit de liaison au second conducteur commun et deux diodes Zener reliant ladite extrémité au conducteur de référence.

7 - Dispositif selon l'une des revendications 2 à 6, caractérisé par le fait que les liaisons entre les dispositifs de mesure respectifs et le dispositif sommateur sont isolées galvaniquement.

8 - Dispositif selon la revendication 1, caractérisé par le fait que le dispositif d'alimentation est constitué d'un second circuit d'alimentation identique au premier, le dispositif sommateur étant relié pour son alimentation à ce second circuit d'alimentation et au second conducteur de phase.

9 - Dispositif selon la revendication 8, caractérisé par le fait que chaque circuit d'alimentation comprend une diode Zener montée entre l'extrémité respective du circuit de liaison et le conducteur de phase respectif, un condensateur en parallèle avec la diode Zener et une diode montée entre ladite extrémité et la borne du condensateur reliée à ladite extrémité.

10 - Dispositif selon l'une des revendications 8 et 9, caractérisé par le fait que seule la liaison entre le premier dispositif de mesure et le dispositif sommateur est isolée galvaniquement.

11 - Dispositif selon l'une des revendications 8 à 10, caractérisé par le fait que chaque circuit d'alimentation est en outre relié au conducteur de référence par un circuit de liaison à forte impédance.

12 - Dispositif selon l'une des revendications 2 à 7 pour un réseau comportant un troisième conducteur de phase et un conducteur de neutre en tant que conducteur de référence, comprenant un troisième dispositif de mesure associé au troisième conducteur de phase, caractérisé par le fait qu'il comprend un troisième circuit d'alimentation relié, d'une part, au troisième conducteur de phase et, d'autre part, au circuit d'alimentation supplémentaire par un troisième circuit de liaison à forte impédance pour appliquer une tension d'alimentation continue et sensiblement stable par rapport au potentiel du troisième conducteur de phase au troisième dispositif de mesure.

13 - Dispositif selon l'une des revendications 1 à 12, dans lequel la grandeur mesurée est l'énergie électrique.

# Fig.1

Fig. 2

# Fig. 3

$R41_1$  $R41_2$  $R41_3$

$D72_1$  $D72_2$  $D72_3$  65

$E50_3$
$E50_1$  $E50_2$

$Z70$

$C63$

$N$  64

$D71_1$  $D71_2$  $D71_3$

# Fig. 4

$C40_1$  $C40_2$  $C40_3$

$R41_1$  $R41_2$  $R41_3$

$D82_1$  $D82_2$  $D82_3$  +5v

76

$E50_1$  $E50_2$  $E50_3$

$C74$

$Z83_1$ $Z84_1$  $Z83_2$ $Z84_2$  $Z83_3$ $Z84_3$

$N$

$D81_1$  $D81_2$  $D81_3$

$C75$

−5v

77

Fig.5

Fig.6

## Fig.7

## Fig.8

Office européen
des brevets

**RAPPORT DE RECHERCHE EUROPEENNE**

Numéro de la demande

EP 81 40 0183

| DOCUMENTS CONSIDERES COMME PERTINENTS | | | CLASSEMENT DE LA DEMANDE (Int. Cl.³) |
|---|---|---|---|
| Catégorie | Citation du document avec indication, en cas de besoin, des parties pertinentes | Revendication concernée | |
| A | FR - A - 2 391 474 (SOCIETE ENERTEC) <br> * page 9, lignes 13 à 40; page 10, lignes 1 à 33; figures 1 et 8 * | 1 | G 01 R 21/00 |
| A | DE - A - 2 619 734 (HELIOWATT) <br> * page 1, revendication 1; figures 1-3 * | 1 | |

**DOMAINES TECHNIQUES RECHERCHES (Int. Cl.³)**

G 01 R 21/00
G 01 R 15/00

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 18.05.1981 | KUSCHBERT |

OEB Form 1503.1 06.78